(19) Europäisches Patentamt
European Patent Office
Office européen des brevets

(11) **EP 1 573 915 B1**

(12) **EUROPÄISCHE PATENTSCHRIFT**

(45) Veröffentlichungstag und Bekanntmachung des Hinweises auf die Patenterteilung:
**16.03.2011 Patentblatt 2011/11**

(21) Anmeldenummer: **03773470.4**

(22) Anmeldetag: **25.09.2003**

(51) Int Cl.:
**H03K 17/00** *(2006.01)*

(86) Internationale Anmeldenummer:
**PCT/DE2003/003264**

(87) Internationale Veröffentlichungsnummer:
**WO 2004/032323 (15.04.2004 Gazette 2004/16)**

(54) **SCHALTUNGSANORDNUNG ZUR ÜBERBRÜCKUNG HOHER SPANNUNGEN MIT EINEM SCHALTSIGNAL**

CIRCUIT ARRANGEMENT FOR BRIDGING HIGH VOLTAGES USING A SWITCHING SIGNAL

CIRCUIT POUR PONTER DE HAUTES TENSIONS AVEC UN SIGNAL DE COMMUTATION

(84) Benannte Vertragsstaaten:
**AT BE BG CH CY CZ DE DK EE ES FI FR GB GR HU IE IT LI LU MC NL PT RO SE SI SK TR**

(30) Priorität: **27.09.2002 DE 10246083**

(43) Veröffentlichungstag der Anmeldung:
**14.09.2005 Patentblatt 2005/37**

(73) Patentinhaber: **Alpha Microelectronics GmbH**
**15236 Frankfurt (Oder) (DE)**

(72) Erfinder:
• **HEINZ, Steffen**
**09217 Burgstädt (DE)**
• **EBEST, Gunter**
**09126 Chemnitz (DE)**

• **DIETRICH, Jürgen**
**15299 Müllrose (DE)**
• **KNOPKE, Jürgen**
**15295 Brieskow-Finkenheerd (DE)**
• **MIESCH, Wolfgang**
**15236 Frankfurt (Oder) (DE)**

(74) Vertreter: **Kailuweit, Frank**
**Patentanwälte Kailuweit & Uhlemann**
**Bamberger Strasse 49**
**01187 Dresden (DE)**

(56) Entgegenhaltungen:
**EP-A- 0 714 130          WO-A-01/56158**
**US-A- 4 504 747          US-A- 4 723 082**
**US-A1- 2003 107 425     US-B1- 6 433 589**

EP 1 573 915 B1

**Beschreibung**

Die Erfindung betrifft Schaltungsanordnungen zur Überbrückung hoher Spannungen mit einem Schaltsignal als dynamische Spannungslevel-Shifter.

Aus der DE 195 02 116 C2 (MOS-Schaltungsanordnung zum Schalten hoher Spannungen auf einem Halbleiterchip) ist eine Realisierung einer integrierten Schaltung auf einem Halbleiterchip zum Schalten höherer Spannungen bekannt. Eine weitere Schaltung zum Schalten hoher Spannungen ist durch die WO 00/70763 bekannt.

Weitere Schaltungen sind durch DECLERCQ, M. u.a.: 5 V-to-75 V CMOS Output Interface Circuits, in: 1993 IEEE International Solid-State Circuits Conference, S.162-163; und BALLAN, H. u.a.: High voltage devices and circuits in standard CMOS technology, Kluwer Academic Publishers, 1999, S.182 ff.; bekannt. Dabei wird ein Konzept für einen statischen Level-Shifter vorgestellt, der aus einem sourcegekoppelten Differenzverstärker mit positiver Rückkopplung besteht. Durch die positive Rückkopplung ist der Verstärker mitgekoppelt und arbeitet als Flip Flop. Die digitale Signalfolge wird invertiert und nicht invertiert auf Transistoren geführt, die über den gesamten Spannungsbereich des Spannungslevel-Shifters arbeiten, das bedeutet, dass diese entsprechend spannungsfest ausgeführt sein müssen. Die Schaltung bildet einen so genannten Spannungsspiegel. Somit wird eine Spannung, welche die Größe des Logikpegel haben sollte, an die obere Spannungsschiene als eine Hochvolt-Versorgungsspannung gespiegelt. Die maximale Spannungsdifferenz zwischen der Schaltungsmasse und der Hochvolt-Versorgungsspannung wird nur von der Spannungsfestigkeit der beiden Transistoren bestimmt.

Aus der JP 2001 - 223 575 A ist ein Spannungslevel-Shifter mit einem Spannungssender mit Anschlüssen (VDD, VSS) für eine Kleinspannung und einem Spannungsempfänger mit Anschlüssen (HVDD, HVSS) für eine gegenüber der Kleinspannung hohen Spannung bekannt. Der Spannungsempfänger besteht aus einer ersten und einer zweiten Inverterschaltung. Der Ausgang einer Inverterschaltung des Spannungssenders ist über eine Kapazität (C1) als Hochspannungskapazität mit dem Eingang einer Inverterschaltung des Spannungsempfängers zusammengeschaltet.

Diese Schaltungen besitzen den Nachteil, dass ein kontinuierlicher Strom zwischen der Hochvolt-Versorgungsspannung und der Schaltungsmasse fließt, der ein wesentlicher Bestandteil der Verlustleistung ist. Diese steigt linear mit der zu überwindenden Spannungsdifferenz. Die Stromhöhe kann nicht beliebig klein gewählt werden, da die Transistorkapazitäten, hauptsächlich der Hochvolt-Transistoren, und parasitäre Schaltungskapazitäten (Leitbahnkapazitäten, Isolationskapazitäten) umgeladen werden müssen. Das beeinflusst sowohl die Verlustleistung als auch die Geschwindigkeit (Grenzfrequenz) der Schaltung. Für Mehrkanalanwendungen und Schaltungen mit hohen Spannungen ist diese Schaltungsvariante ungeeignet. Der zweite Nachteil liegt im Platzbedarf der Schaltungen. Die Hochvolt-Transistoren belegen jeweils nach Spannungsfestigkeit eine große Chipfläche. Bei mehrkanaligen Systemen addiert sich diese Fläche zu einem erheblichen Teil der Gesamtchipfläche.

Durch die US 4,723,082 (Signal transfer circuit for use in laminated multilayer electric circuit) ist eine Schaltungsanordnung zur Überbrückung von unterschiedlichen Spannungen mit einem Schaltsignal bekannt. Dabei ist ein Spannungssender mit ersten und zweiten Anschlüssen für eine Kleinspannung und ein Spannungsempfänger mit dritten und vierten Anschlüssen für eine gegenüber der Kleinspannung zwischen den ersten und zweiten Anschlüssen unterschiedlichen Spannung verbunden. Der Spannungssender und der Spannungsempfänger bestehen jeweils aus einer ersten und einer zweiten Inverterschaltung. Dabei sind sowohl der Ausgang der ersten Inverterschaltung des Spannungssenders über eine erste Kapazität mit dem Eingang der zweiten Inverterschaltung des Spannungsempfängers und dem Ausgang der ersten Inverterschaltung des Spannungsempfängers als auch der Ausgang der zweiten Inverterschaltung des Spannungssenders über eine zweiten Kapazität mit dem Eingang der ersten Inverterschaltung des Spannungsempfängers und dem Ausgang der zweiten Inverterschaltung des Spannungsempfängers zusammengeschaltet. Weiterhin sind die Eingänge der ersten Inverterschaltung und der zweiten Inverterschaltung jeweils des Spannungssenders ein nicht invertierender und ein invertierender Eingang. Die Ausgänge der ersten Inverterschaltung und der zweiten Inverterschaltung des Spannungsempfängers stellen Ausgangsknoten dar.

Die vorgestellte Schaltungsanordnung hat den Nachteil, dass zur Regenerierung des Signals im Spannungsempfänger 8 Transistoren benötigt werden.

Der im Patentanspruch 1 angegebenen Erfindung liegt das Problem zugrunde, eine Hochvolt-Schaltung zu schaffen, die Schaltsignalfolgen auf verschiedenen Spannungsebenen verarbeiten oder zur Verfügung stellen kann.

Dieses Problem wird mit den im Patentanspruch 1 aufgeführten Merkmalen gelöst.

Die Schaltungsanordnungen zur Überbrückung hoher Spannungen mit einem Schaltsignal als dynamische Spannungslevel-Shifter zeichnen sich insbesondere dadurch aus, dass Schaltsignalfolgen auf verschiedenen Spannungsebenen verarbeitet oder zur Verfügung gestellt werden können. Ein wesentlicher Vorteil besteht darin, dass beliebige Technologien für integrierte Hochvolt-Schaltungen mit einer beliebigen Isolationsmethode zur Realisierung der erfindungsgemäßen Schaltungsanordnungen zum Umschalten hoher Spannungen angewandt werden können.

Die Schaltungsanordnungen zum Umschalten hoher Spannungen, auch als dynamische Spannungslevel-Shifter bezeichnet, dienen dazu, digitale Signalpegel mit üblichen Spannungspegeln zwischen ca. 3 V bis 15 V über eine Potentialdifferenz von einigen Volt bis zu einigen hundert Volt (je nach verwendeter Technologie und Anwendung) auf einer anderen Spannungsebene zur Verfügung zu stellen. Dabei kann die Potentialdifferenz zwischen der Eingangsspannungsebene, die synonym als Spannungssender bezeichnet wird, und der Ausgangsspannungsebene, die synonym als Spannungsempfänger bezeichnet wird, sowohl positiv oder negativ sein als auch in der Potentialhöhe variieren.

Die Schaltungsanordnungen zur Überbrükkung hoher Spannungen mit einem Schaltsignal bestehen aus Inverterschaltungen. Die des Spannungssenders sind mit den Anschlüssen Vdd und Vss für eine Kleinspannung und die des Spannungsempfängers sind mit Anschlüssen Vddh1 und Vddh2 für eine gegenüber der Schaltungsmasse Vss hohen Spannung zusammengeschaltet. Die Verbindungen des Spannungssenders und des Spannungsempfängers erfolgen über Kapazitäten C1 und C2 als Hochvoltkapazitäten, so dass zwischen den Spannungsebenen in Form des Spannungssenders und des Spannungsempfängers kein kontinuierlicher Stromfluss vorhanden ist. Die Signalübertragung erfolgt mit Hilfe einer kleinen Ladungsmenge DQ, die wechselseitig auf- und entladen wird. Damit ist ein Differentialbetrieb gegeben, so dass weiterhin vorteilhafterweise ein hoher Störabstand gegenüber parasitären Signaleinkopplungen aufgrund des Differentialprinzips, C1 wird um die Ladung DQ aufgeladen und C2 gleichzeitig um die Ladung DQ entladen und umgekehrt, erreicht wird. Die erforderlichen spannungsfesten Bauelemente der erfindungsgemäßen Schaltungsanordnung sind auf die zwei Hochvolt-Kapazitäten beschränkt. Diese können geschichtet ausgeführt werden, so dass ein kleiner Platzbedarf bei höheren Kapazitäten pro Fläche notwendig ist.

Die Inverterschaltungen des Spannungsempfängers sind kreuzgekoppelt, so dass im Spannungsempfänger keine Schutzdioden benötigt werden, um nachfolgende Bauelemente vor Spannungsspitzen zu schützen. Ein weiterer Vorteil dieser Kreuzkopplung besteht darin, dass kleinere Hochvolt-Kapazitäten C1 und C2 benötigt werden. Es müssen ausschließlich die parasitären Kapazitäten der kreuzgekoppelten Inverterschaltungen überwunden werden. Ihre Kapazität kann sehr klein sein, so dass auch reduzierte Chipflächen zur Realisierung dieser Kapazitäten notwendig sind.

Eine dritte Inverterschaltung des Spannungssenders zwischen den Anschlüssen Vdd und Vss, wobei deren Ausgang mit dem Eingang der ersten Inverterschaltung des Spannungssenders und deren Eingang sowohl mit dem Eingang der zweiten Inverterschaltung des Spannungssenders als auch mit dem Anschluss IN als Eingang der Schaltungsanordnung zur Überbrükkung hoher Spannungen mit einem Schaltsignal zusammengeschaltet sind, führt dazu, dass ausgehend von einem Low-Signal am Eingang IN das Signal zweifach invertiert wird, so daß dieses phasengleich zum Eingangssignal auf die Kapazität C1 geführt wird. Über die zweite Inverterschaltung des Spannungssenders gelangt das Signal invertiert auf die Kapazität C2. Damit ist ein Differentialbetrieb gegeben.

Eine vierte und eine fünfte Inverterschaltung des Spannungssenders zwischen den Anschlüssen Vdd und Vss, wobei der Eingang der fünften Inverterschaltung mit dem Eingang der dritten Inverterschaltung und mit dem Anschluss IN als Eingang der Schaltungsanordnung zur Überbrückung hoher Spannungen mit einem Schaltsignal, der Ausgang der fünften Inverterschaltung mit dem Eingang der vierten Inverterschaltung und der Ausgang der vierten Inverterschaltung mit dem Eingang der zweiten Inverterschaltung des Spannungssenders zusammengeschaltet sind, sind vorteilhafterweise Treiberstufen. Dadurch gelangt das Signal ausgehend von einem Low-Signal am Eingang IN invertiert auf die Kapazität C2.

Damit gelangt das Signal ausgehend von einem Low-Signal (ca. 0 V) am Eingang IN der Schaltungsanordnung über die fünfte Inverterschaltung, die vierte Inverterschaltung und die zweite Inverterschaltung des Spannungssenders invertiert auf die Kapazität C2. Die Aufteilung auf mehrere hintereinander geschaltene Inverterschaltungen führt vorteilhafterweise zu höheren Treiberleistungen und damit steileren Schaltflanken.

Die Schaltungsanordnungen zur Überbrükkung hoher Spannungen mit einem Schaltsignal sind vorteilhafterweise richtungsunabhängig, so dass sowohl eine positive als auch eine negative Spannungsdifferenz zwischen dem Spannungssender und dem Spannungsempfänger überwindbar ist.

Damit eignen sich die Schaltungsanordnungen zur Überbrückung hoher Spannungen mit einem Schaltsignal für Hochvolt-Schaltungen, die Schaltsignalfolgen auf verschiedenen Spannungsebenen verarbeiten oder zur Verfügung stellen. Anwendungen sind zum Beispiel Motortreiber-Schaltungen, Audio-Verstärker nach dem class-D-Prinzip oder Ansteuerschaltungen für elektrostatische Aktoren. Elektrostatische Aktoren sind unter anderem Piezokeramikstrukturen oder Schwenkspiegelarrays.

Vorteilhafte Ausgestaltungen der Erfindung sind in den Patentansprüchen 2 bis 7 angegeben.

Eine dritte und eine vierte Inverterschaltung zwischen den Anschlüssen Vddh1 und Vddh2, wobei der Eingang der dritten Inverterschaltung mit dem Eingang der ersten Inverterschaltung des Spannungsempfängers, der Eingang der vierten Inverterschaltung mit dem Eingang der zweiten Inverterschaltung des Spannungsempfängers, der Ausgang der dritten Inverterschaltung mit dem Anschluss OUT1 als erstem Ausgang des Spannungsempfängers und der Ausgang der vierten Inverterschaltung mit dem Anschluss OUT2 als zweitem Ausgang des Spannungsempfängers zusammengeschaltet sind, nach der Weiterbildung des Patentanspruchs 2 sind Ausgangsinverter, wobei ausgehend von einem Low-Signal am Eingang des Spannungssenders am Ausgang OUT1 ein Low-Signal bezogen auf die Hochvolt-Spannungsversorgung und am Ausgang OUT2 ein High-Signal bezogen auf die Hochvolt-Spannungsversorgung entstehen.

Die Weiterbildung des Patentanspruchs 3, wobei die Inverterschaltungen aus zwei in Reihe geschalteter komplementärer Transistoren bestehen, führt zu Inverterschaltungen mit nahezu idealen Verhalten. Beide Transistoren sind abwechselnd das aktive Element und das Lastelement. Im Ruhezustand ist der Leistungsverbrauch beim Einsatz von MOSFETs sehr gering. Diese sind nur durch Leckströme bedingt. Ein Leistungsverbrauch tritt nur während des Umschaltens und damit proportional zur Arbeitsfrequenz auf. Dieser entsteht durch die Umladung der Lastkapazitäten und zum geringen Teil durch einen Querstrom.

Die Kapazitäten zur Signalübertragung zwischen dem Spannungssender und dem Spannungsempfänger werden entsprechend der Weiterbildung des Patentanspruchs 4 auf die zu überwindende Spannungsdifferenz aufgeladen. Zur Signalübertragung variiert ihr Betrag lediglich nur um DQ, wobei der Leistungsverbrauch unabhängig von der zu überwindenden Spannungsdifferenz ist.

Eine Realisierung der Schaltungsanordnungen zur Überbrückung hoher Spannungen mit einem Schaltsignal als mit Halbleiterprozessen hergestellte integrierte Halbleiterschaltungen zum Einen mit CMOS-Schaltungen als Inverterschaltungen und zum Anderen mit Schichtstapeln mit Kanalstopper-Implantation, Feldoxid, Polysilizium, CVD-Oxid, Metall, CVD-Oxid, Metall usw., wobei die Schichten wechselseitig elektrisch verschalten sind, als Kapazitäten nach der Weiterbildung des Patentanspruchs 5 erfüllen vorteilhafterweise die Forderungen nach geringem Leistungsverbrauch und geringem Platzbedarf.

Die Weiterbildung des Patentanspruchs 6, wobei der Spannungssender, die Kapazitäten und der Spannungsempfänger jeweils von Trenchgräben zur Spannungsisolation umgebende Gebiete sind, stellt eine günstige Realisierung dar.

Ein wesentlicher Vorteil der Schaltungsanordnungen zur Überbrückung hoher Spannungen mit einem Schaltsignal besteht nach der Weiterbildung des Patentanspruchs 7 darin, dass Halbleiterprozesse für integrierte Hochvolt-Schaltungen mit beliebiger Isolation für den Spannungssender, die Hochvoltkapazitäten und den Spannungsempfänger angewandt werden können. Damit ergeben sich die vielfältigsten Realisierungsvarianten entsprechend ökonomischer Forderungen, verfahrenstechnischer Herstellungsvoraussetzungen und/ oder geforderter Anwenderspezifika.

Ein Ausführungsbeispiel der Erfindung ist in den Zeichnungen dargestellt und wird im folgenden näher beschrieben.

Es zeigen:

Fig. 1 ein Blockschaltbild der Basisschaltung einer Schaltungsanordnung zum Umschalten hoher Spannungen,
Fig. 2 eine Realisierung der Basisschaltung einer Schaltungsanordnung zum Umschalten hoher Spannungen,
Fig. 3 eine Schaltungsanordnung zum Umschalten hoher Spannungen,
Fig. 4 eine Schaltungsanordnung zum Umschalten hoher Spannungen und
Fig. 5 eine prinzipielle Darstellung von Gebieten einer Realisierung einer Schaltungsanordnung zum Umschalten hoher Spannungen auf einem Halbleiterchip.

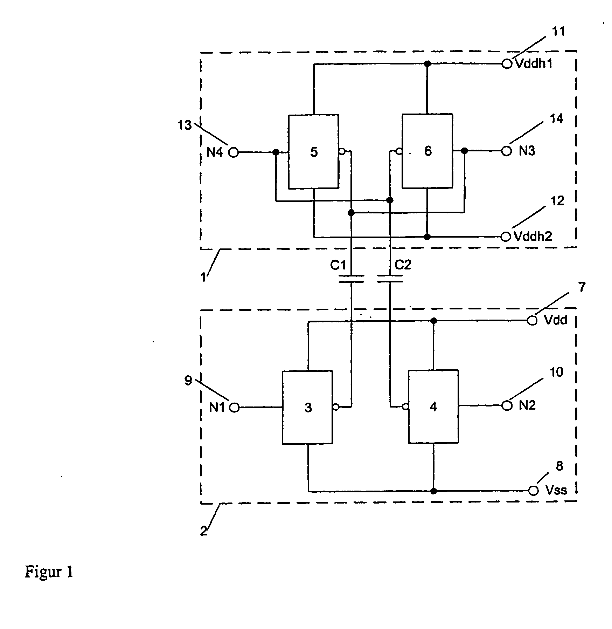

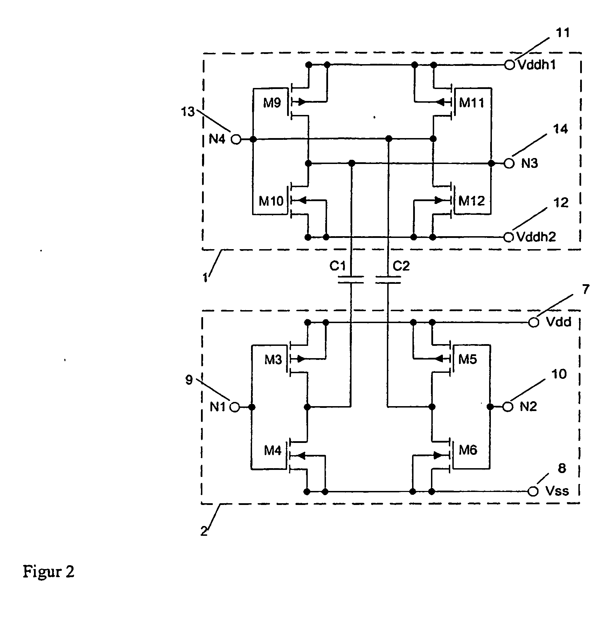

Eine Schaltungsanordnung zur Überbrückung hoher Spannungen mit einem Schaltsignal als dynamischer Spannungslevel-Shifter besteht aus einem Spannungssender 2 mit den Anschlüssen Vdd 7, Vss 8 für eine Kleinspannung und einem Spannungsempfänger 1 mit den Anschlüssen Vddh1 11, Vddh2 12 für die gegenüber der Kleinspannung zwischen den Anschlüssen Vdd 7 und Vss 8 hohen Spannung aus jeweils einer ersten Inverterschaltung und einer zweiten Inverterschaltung. Die Fig. 1 zeigt ein Blockschaltbild der Basisschaltung einer Schaltungsanordnung zur Überbrückung hoher Spannungen mit einem Schaltsignal und die Fig. 2 eine Realisierung dieser Basisschaltung.

Die Inverterschaltungen des Spannungssenders 2 sind zwischen die Anschlüsse Vdd 7 und Vss 8, wobei Vss 8 die Schaltungsmasse ist, und die Inverterschaltungen des Spannungsempfängers 1 zwischen die Anschlüsse Vddh1 11 und Vddh2 12 geschalten. Der Ausgang der ersten Inverterschaltung 3 des Spannungssenders 2 ist über eine erste Kapazität C1 als Hochspannungskapazität mit dem Eingang der zweiten Inverterschaltung 6 des Spannungsempfängers 1 und mit dem Ausgang der ersten Inverterschaltung 5 des Spannungsempfängers 1 und der Ausgang der zweiten Inverterschaltung 4 des Spannungssenders 2 ist über eine zweite Kapazität C2 als Hochspannungskapazität mit dem Eingang der ersten Inverterschaltung 5 des Spannungsempfängers 1 und dem Ausgang der zweiten Inverterschaltung 6 des Spannungsempfängers 1 zusammengeschaltet (Darstellung in der Fig. 1). Die Eingänge der ersten Inverterschaltung 3 und der zweiten Inverterschaltung 4 jeweils des Spannungssenders 2 stellen einen nicht invertierenden und einen invertierenden Eingang dar. Die Ausgänge der ersten Inverterschaltung 5 und der zweiten Inverterschaltung 6 jeweils des Spannungsempfängers 1 sind Ausgangsknoten.

Die Inverterschaltungen 3, 4, 5, 6 bestehen jeweils aus zwei in Reihe geschalteten komplementären Transistoren (Darstellung in der Fig. 2). Dabei sind folgende Zuordnungen gegeben:

- erste Inverterschaltung 3 des Spannungssenders 2 Transistoren M3, M4,

- zweite Inverterschaltung 4 des Spannungssenders 2 Transistoren M5, M6,
- erste Inverterschaltung 5 des Spannungsempfängers 1 Transistoren M9, M10 und
- zweite Inverterschaltung 6 des Spannungsempfängers 1 Transistoren M11, M12.

Alle Transistoren sind MOSFETs (MOSFET - Abkürzung des metal oxide silicon field effect transistor).
Mit einer derartigen Realisierung entsteht zwischen dem Spannungssender 2 und dem Spannungsempfänger 1 und damit zwischen der Spannungsebene Vdd - Vss und der Spannungsebene Vddh1 - Vddh2 kein kontinuierlicher Stromfluss. Die Signalübertragung erfolgt mit Hilfe einer kleinen Ladungsmenge DQ, die wechselseitig auf- und entladen wird. Aufgrund der kreuzgekoppelten Anordnung der ersten Inverterschaltung 5 des Spannungsempfängers 1 und der zweiten Inverterschaltung 6 des Spannungsempfängers 1 werden keine Schutzdioden benötigt, so dass kleine Kapazitäten C1, C 2 jeweils als Hochvolt-Kapazitäten einsetzbar sind. Gleichzeitig kann sowohl eine positive als auch eine negative Spannungsdifferenz zwischen dem Spannungssender 2 und dem Spannungsempfänger 1 überwunden werden. Die durch die erfindungsgemäße Schaltungsanordnung zu überwindende Spannungsdifferenz liegt zwischen den Versorgungsspannungen zum Einen Vdd - Vss und zum Anderen Vddh1 - Vddh2, wobei diese ein positives als auch negatives Vorzeichen besitzen und gleichzeitig im Betrag variieren kann. Der maximale Betrag der zu überwindenden Spannungsdifferenz ist ausschließlich von der Spannungsfestigkeit der beiden Kapazitäten C1, C2 abhängig. Die Funktion besteht darin, dass die beiden Kapazitäten C1, C2 auf die zu überwindende Spannungsdifferenz aufgeladen werden und ihre Ladung anschließend lediglich um den kleinen Betrag

$$DQ = C \times (Vdd - Vss) \quad /1/$$

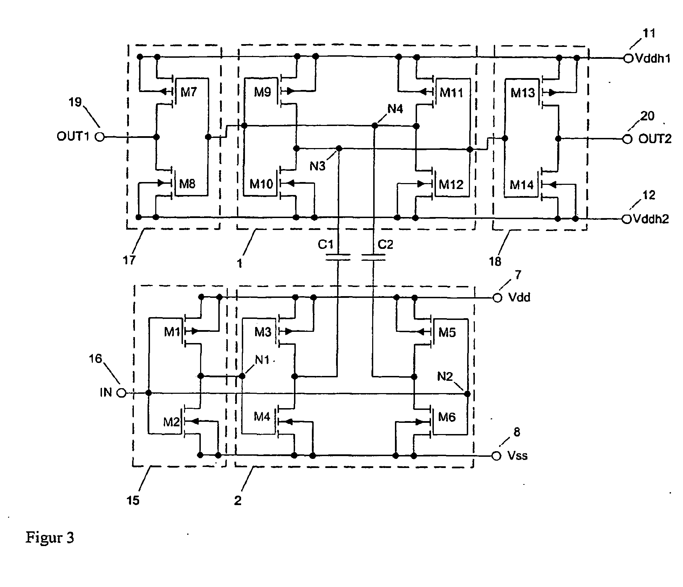

zur Signalübertragung variiert. Die Spannungsdifferenz (Vdd-Vss) entspricht der Niedervolt-Versorgungsspannung zwischen den Anschlüssen 7 und 8. Der Umladeimpuls bei einer Low-High-Flanke am Eingang N1 9 wird über die erste Inverterschaltung 3 des Spannungssenders 2, bestehend aus den Transistoren M3 und M4, auf die Kapazität C1 übertragen. Das am Knoten N210 invertiert anliegende Signal (High-Low-Flanke) wird gleichzeitig über die zweite Inverterschaltung 4 des Spannungssenders 2, bestehend aus den Transistoren M5 und M6, auf die Kapazität C2 übertragen. Die Kapazität C1 wird senderseitig um den Betrag aus Gleichung /1/ aufgeladen und die Kapazität C2 entladen (Differentialprinzip). Diese Ladung wird über die zu überwindende Spannungsdifferenz an den Spannungsempfänger 1 weitergegeben.
Durch die beschriebene Arbeitsweise kann der Stromverbrauch sehr stark reduziert werden und der Leistungsverbrauch der erfindungsgemäßen Schaltungsanordnung ist praktisch unabhängig von der zu überwindenden Spannungsdifferenz. Gleichzeitig garantiert das angewandte Differentialprinzip (C1 wird um DQ aufgeladen, C2 wird um DQ entladen und umgekehrt) einen hohen Störabstand gegenüber Gleichtaktstörsignale.
Weiterhin genügen sehr kleine Kapazitätswerte für die Kapazitäten C1, C2, da ausschließlich die parasitären Kapazitäten der kreuzgekoppelten Inverterschaltungen 5, 6 überwunden werden müssen. Gleichzeitig übernehmen diese die Schutzfunktion vor Über- oder Unterspannung der weiteren Schaltung. Ansonsten notwendige Schutzdioden können entfallen.
Bei einer ersten Ausführungsform des Ausführungsbeispiels ist eine dritte Inverterschaltung 15 des Spannungssenders 2 zwischen die Anschlüsse Vdd 7 und Vss 8 so geschalten, dass der Ausgang der dritten Inverterschaltung 15 mit dem Eingang der ersten Inverterschaltung 3 des Spannungssenders 2 und der Eingang der dritten Inverterschaltung 15 mit dem Eingang der zweiten Inverterschaltung 4 des Spannungssenders 2 und dem Anschluss IN 16 als Eingang der Schaltungsanordnung zur Überbrückung hoher Spannungen mit einem Schaltsignal als dynamischer Spannungslevel-Shifter verbunden sind.
Weiterhin sind eine dritte Inverterschaltung 17 und eine vierte Inverterschaltung 18 des Spannungsempfängers 1 zwischen die Anschlüsse Vddh1 11 und Vddh2 12 geschalten. Dabei sind der Eingang der dritten Inverterschaltung 17 mit dem Eingang der ersten Inverterschaltung 5 des Spannungsempfängers 1, der Eingang der vierten Inverterschaltung 18 mit dem Eingang der zweiten Inverterschaltung 6 des Spannungsempfängers 1, der Ausgang der dritten Inverterschaltung 17 mit dem Anschluss ORT1 19 als erstem Ausgang des Spannungsempfängers 1 und der Ausgang der vierten Inverterschaltung 18 mit dem Anschluss OUT2 20 als zweitem Ausgang des Spannungsempfängers 1 zusammengeschaltet. Die dritte Inverterschaltung 15 ist ein Eingangsinverter für den Spannungssender 2 und die dritte Inverterschaltung 17 und die vierte Inverterschaltung 18 sind Ausgangsinverter des Spannungsempfängers 1. Die Fig. 3 zeigt eine derartig realisierte Schaltungsanordnung zur Überbrückung hoher Spannungen mit einem Schaltsignal.
Die Versorgungsspannungen des Spannungssenders 2 zwischen den Anschlüssen Vdd 7 und Vss 8 und des Spannungsempfängers zwischen Vddh1 11 und Vddh2 12 haben jeweils die Größe von beispielsweise 12 V. Die zu überwindende Spannungsdifferenz zwischen Spannungssender 2 und Spannungsempfänger 1, daß heißt zwischen Anschluss Vss 8 und Anschluss Vddh1 11 beträgt beispielsweise 200 V. Daraus resultiert für die Kapazitäten C1, C2 ein Spannungsabfall von ca. 188 V.
Ausgehend von einem Low-Signal (ca. 0 V) am Eingang IN 16, wird das Signal zweifach invertiert (d.h.

phasengleich zum Eingangssignal) durch die dritte Inverterschaltung 15, bestehend aus den Transistoren M1 und M2, und der ersten Inverterschaltung 3 des Spannungssenders 2, bestehend aus den Transistoren M3 und M4, auf die Kapazität C1 geführt. Über die zweite Inverterschaltung 4 des Spannungssenders 2, bestehend aus den Transistoren M5 und M6, gelangt das Signal invertiert auf die Kapazität C2.

Damit ergibt sich für die Kapazität C1 ein Spannungsabfall von 188 V zwischen den Spannungspotentialen 0 V und 188 V, und für die Kapazität C2 ein Spannungsabfall von 188 V zwischen den Spannungspotentialen 12 V und 200 V jeweils bezogen auf die Schaltungsmasse am Anschluss Vss 8. Damit liegt am Ausgangsknoten N3 14 des Spannungsempfängers 1 ein Spannungspotential von ca. 188 V und am Ausgangsknoten N4 13 ein Spannungspotential von ca. 200 V an. Über die dritte Inverterschaltung 17 des Spannungsempfängers 1, bestehend aus den Transistoren M7 und M8, entsteht am Ausgang OUT1 19 ein Low-Signal bezogen auf die Spannung zwischen Vddh1 11 und Vddh2 12, daß heißt ein Potential gegenüber dem Anschluss Vss 8 von ca. 188 V. Am Ausgang OUT2 20 ergibt sich über die vierte Inverterschaltung 18 des Spannungsempfängers 1, bestehend aus den Transistoren M13 und M14, ein High-Signal bezogen auf die Spannung zwischen Vddh1 11 und Vddh2 12, daß heißt ein Potential gegenüber Anschluss Vss 8 von ca. 200 V. Am Ausgang OUT1 19 steht demzufolge das Signal um die zu überbrückenden Spannungsdifferenz verschoben wieder zur Verfügung. Am Ausgang OUT2 20 kann das invertiert anliegende Signal abgegriffen werden.

Wechselt am Eingang IN 16 des Spannungssenders 2 das Low-Signal zu einem High-Signal erhöht sich die Ladung der Kapazität C1 um den Betrag DQ und die Ladung auf der Kapazität C2 verringert sich um den Betrag DQ (Gleichung /1/). Diese Ladungsänderung wird an den Spannungsempfänger 1 weitergegeben und führt dazu, dass die kreuzgekoppelte Inverterschaltung in den zweiten stabilen Zustand umkippt. Dadurch wechselt sowohl die dritte Inverterschaltung 17 des Spannungsempfängers 1 ihr Ausgangssignal am Ausgang OUT1 19 auf ein High-Signal bezogen auf die Spannung zwischen Vddh1 11 und Vddh2 12 als auch die vierte Inverterschaltung 18 des Spannungsempfängers 1 ihr Ausgangssignal am Ausgang OUT2 20 auf ein Low-Signal bezogen auf die Spannung zwischen Vddh1 11 und Vddh2 12.

Bei einer zweiten Ausführungsform des Ausführungsbeispiels in Ergänzung der ersten Ausführungsform sind eine vierte Inverterschaltung 21 und eine fünfte Inverterschaltung 22 des Spannungssenders 2 zwischen die Anschlüsse Vdd 7 und Vss 8 geschalten. Dabei sind der Eingang der fünften Inverterschaltung 22 mit dem Eingang der dritten Inverterschaltung 15 und mit dem Anschluss IN 16 als Eingang der Schaltungsanordnung zur Überbrückung hoher Spannungen mit einem Schaltsignal, der Ausgang der fünften Inverterschaltung 22 mit dem Eingang der vierten Inverterschaltung 21 und der Ausgang der vierten Inverterschaltung 21 mit dem Eingang der zweiten Inverterschaltung 4 des Spannungssenders 2 zusammengeschaltet.

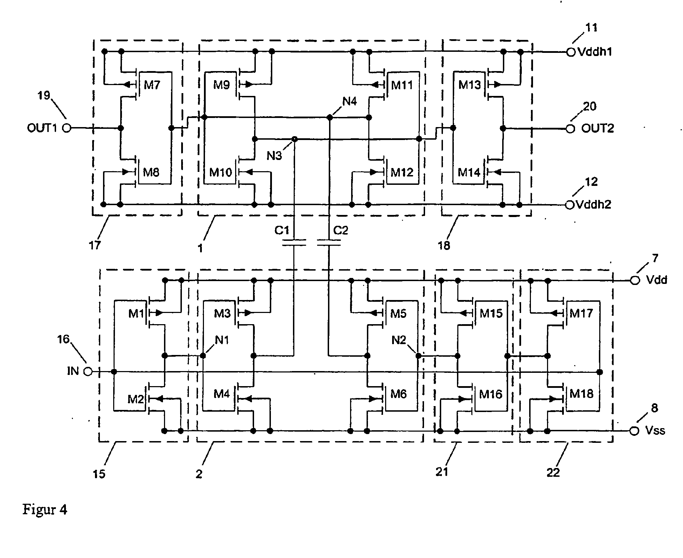

Die vierte Inverterschaltung 21, bestehend aus den Transistoren M15 und M16, und die fünfte Inverterschaltung 22 des Spannungssenders 2, bestehend aus den Transistoren M17 und M18, sind Treiberstufen (Darstellung in der Fig. 4).

In Abwandlung der ersten Ausführungsform gelangt das Signal ausgehend von einem Low-Signal (ca. 0 V) am Eingang IN 16 der Schaltungsanordnung über die fünfte Inverterschaltung 22, die vierte Inverterschaltung 21 und die zweite Inverterschaltung 4 des Spannungssenders 2 invertiert auf die Kapazität C2. Die weitere Funktion entspricht der der ersten Ausführungsform. Die Aufteilung auf mehrere hintereinander geschaltene Inverterschaltungen, in dieser Ausführungsform die fünfte Inverterschaltung 22 und die vierte Inverterschaltung 21, führt zu höheren Treiberleistungen und damit steileren Schaltflanken.

Die Schaltungsanordnungen zur Überbrückung hoher Spannungen mit einem Schaltsignal als dynamische Spannungslevel-Shifter können als mit Halbleiterprozessen hergestellte integrierte Halbleiterschaltungen zum Einen mit CMOS-Schaltungen (CMOS - Abkürzung von complemetary metal oxide semiconductor) als Inverterschaltungen und zum Anderen Schichtstapel mit Kanalstopper-Implantation, Feldoxid, Polysilizium, CVD-Oxid (CVD - Abkürzung von chemical vapour deposition - chemische Dampfabscheidung), Metall, CVD-Oxid, Metall usw., wobei die Schichten wechselseitig elektrisch verschaltet sind, als erste Kapazität C1 und als zweite Kapazität C2 realisiert werden. Die einzelnen Bestandteile der Schaltungsanordnung zur Überbrückung hoher Spannungen mit einem Schaltsignal sind wie folgt Gebiete eines Halbleiterchips:

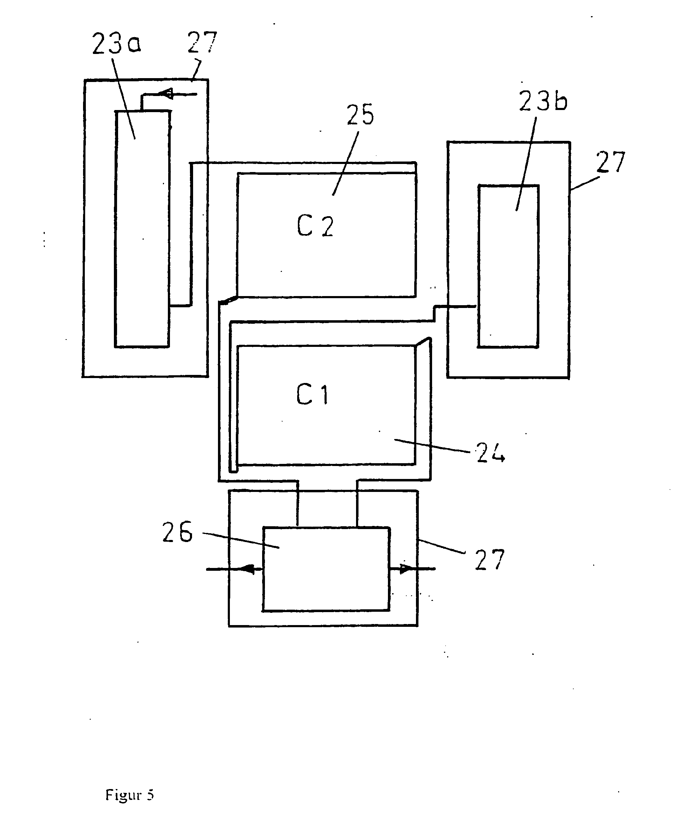

- zwei Gebiete 23a, 23b sind der Spannungssender 2,
- ein Gebiet 24 ist die erste Kapazität C1,
- ein Gebiet 25 ist die zweite Kapazität C2 und
- ein Gebiet 26 ist der Spannungsempfänger 1, wobei die Gebiete jeweils von Trenchgräben 27 zur Spannungsisolation umgeben sind (Darstellung in der Fig. 5). Der Flächenbedarf für eine Kapazität C1, C2 von ca. 0,8 pF beträgt dabei zum Beispiel ca. 10 000 $\mu m^2$.

Die Schaltungsanordnungen zur Überbrückung höher Spannungen mit einem Schaltsignal können einkanalig oder mehrkanalig auf einem Halbleiterchip ausgeführt sein.

**Patentansprüche**

1.    Schaltungsanordnung zur Überbrückung hoher Spannungen mit einem Schaltsignal, wobei

- ein Spannungssender (2) mit ersten und zweiten Anschlüssen (7/Vdd, 8/Vss) für eine Kleinspannung und ein Spannungsempfänger (1) mit dritten und vierten Anschlüssen (11/Vddh1, 12Nddh2) für eine gegenüber der Kleinspannung zwischen den ersten und zweiten Anschlüssen (7/Vdd, 8/Vss) hohen Spannung aus jeweils einer ersten Inverterschaltung und einer zweiten Inverterschaltung bestehen, wobei die Inverterschaltungen des Spannungssenders (2) zwischen die ersten und zweiten Anschlüsse (7/Vdd, 8/Vss) und die Inverterschaltungen des Spannungsempfängers (1) zwischen die dritten und vierten Anschlüsse (11/Vddh1, 12/Vddh2) geschalten sind,

- der Ausgang der ersten Inverterschaltung (3) des Spannungssenders (2) über eine erste Kapazität (C1) als Hochspannungskapazität mit dem Eingang der zweiten Inverterschaltung (6) des Spannungsempfängers (1) und dem Ausgang der ersten Inverterschaltung (5) des Spannungsempfängers (1) und

- der Ausgang der zweiten Inverterschaltung (4) des Spannungssenders (2) über eine zweite Kapazität (C2) als Hochspannungskapazität mit dem Eingang der ersten Inverterschaltung (5) des Spannungsempfängers (1) und dem Ausgang der zweiten Inverterschaltung (6) des Spannungsempfängers (1) zusammengeschaltet sind,

- die Eingänge der ersten Inverterschaltung (3) und der zweiten Inverterschaltung (4) jeweils des Spannungssenders (2) ein nicht invertierender und ein invertierender Eingang sind und

- die Ausgänge der ersten Inverterschaltung (5) und der zweiten Inverterschaltung (6) jeweils des Spannungsempfängers (1) Ausgangsknoten darstellen, **dadurch gekennzeichnet,**

- **dass** eine dritte Inverterschaltung (15) des Spannungssenders (2) zwischen die ersten und zweiten Anschlüsse (7/Vdd, 8/Vss) geschalten ist,

- **dass** der Ausgang der dritten Inverterschaltung (15) mit dem Eingang der ersten Inverterschaltung (3) des Spannungssenders (2),

- **dass** der Eingang der dritten Inverterschaltung (15) mit dem Eingang der zweiten Inverterschaltung (4) des Spannungssenders (2),

- **dass** der Eingang der dritten Inverterschaltung (15) mit dem Anschluss IN (16) als Eingang der Schaltungsanordnung zur Überbrückung hoher Spannungen mit einem Schaltsignal zusammengeschaltet sind,

- **dass** eine vierte Inverterschaltung (21) und eine fünfte Inverterschaltung (22) des Spannungssenders (2) zwischen die ersten und zweiten Anschlüsse (7/Vdd, 8/Vss) geschalten sind,

- **dass** der Eingang der fünften Inverterschaltung (22) mit dem Eingang der dritten Inverterschaltung (15) und mit dem Anschluss IN (16) als Eingang der Schaltungsanordnung zur Überbrückung hoher Spannungen mit einem Schaltsignal,

- **dass** der Ausgang der fünften Inverterschaltung (22) mit dem Eingang der vierten Inverterschaltung (21) und

- **dass** der Ausgang der vierten Inverterschaltung (21) mit dem Eingang der zweiten Inverterschaltung (4) des Spannungssenders (2) zusammengeschaltet sind.

2. Schaltungsanordnung nach Patentanspruch 1, **dadurch gekennzeichnet, dass** eine dritte Inverterschaltung (17) und eine vierte Inverterschaltung (18) des Spannungsempfängers (1) zwischen die dritten und vierten Anschlüsse (11/Vddh1, 12/Vddh2) geschalten sind, dass der Eingang der dritten Inverterschaltung (17) mit dem Eingang der ersten Inverterschaltung (5) des Spannungsempfängers (1), dass der Eingang der vierten Inverterschaltung (18) mit dem Eingang der zweiten Inverterschaltung (6) des Spännungsempfängers (1), dass der Ausgang der dritten Inverterschaltung (17) mit dem Anschluss OUT1 (19) als erstem Ausgang des Spannungsempfängers (1) und dass der Ausgang der vierten Inverterschaltung (18) mit dem Anschluss OUT2 (20) als zweitem Ausgang des Spannungsempfängers (1) zusammengeschaltet sind.

3. Schaltungsanordnung nach den Patentansprüchen 1 und 2, **dadurch gekennzeichnet, dass** eine Inverterschaltung aus zwei in Reihe geschalteter komplementärer Transistoren besteht.

4. Schaltungsanordnung nach Patentanspruch 1, **dadurch gekennzeichnet, dass** die erste Kapazität (C1) und die zweite Kapazität (C2) so zwischen dem Spannungssender (2) und dem Spannungsempfänger (1) geschalten sind, dass die erste Kapazität (C1) und die zweite Kapazität (C2) jeweils als Hochspannungskapazität auf die zu überwindende Spannungsdifferenz zwischen dem Spannungssender (2) und dem Spannungsempfänger (1) aufgeladen werden und ihre Ladung anschließend lediglich um den Betrag DQ = C x (Vdd - Vss) zur Signalübertragung variiert, wobei der Leistungsverbrauch der Schaltungsanordnung zur Überbrückung hoher Spannungen mit einem Schaltsignal unabhängig von der zu überwindenden Spannungsdifferenz zwischen dem Spannungssender (2) und dem Spannungsempfänger (1) ist und gleichzeitig das angewandte Differentialprinzip (C1 wird um DQ aufgeladen, C2 wird um DQ entladen und umgekehrt) einen hohen Störabstand gegenüber Gleichtaktstörsignalen garantiert.

5. Schaltungsanordnung nach Patentanspruch 1, **da-**

**durch gekennzeichnet, dass** die Schaltungsanordnung zur Überbrückung hoher Spannungen mit einem Schaltsignal als mit Halbleiterprozessen hergestellte integrierte Halbleiterschaltung zum Einen mit CMOS-Schaltungen als Inverterschaltungen und zum Anderen Schichtstapel mit Kanalstopper-Implantation, Feldoxid, Polysilizium, CVD-Oxid, Metall, CVD-Oxid, Metall usw., wobei die Schichten wechselseitig elektrisch verschaltet sind, als erste Kapazität (C1) und als zweite Kapazität (C2) jeweils als Hochvoltkapazitäten realisiert ist.

6. Schaltungsanordnung nach den Patentansprüchen 1 bis 5, **dadurch gekennzeichnet, dass** der Spannungssender (2) ein Gebiet oder mehrere Gebiete (23a, 23b), dass die erste Kapazität (C1) ein Gebiet (24) und die zweite Kapazität (C2) ein Gebiet (25) und dass der Spannungsempfänger (1) ein Gebiet (26) des Halbleiterchips sind und dass wenigstens die Gebiete des Spannungssenders (2) oder des Spannungssenders (2) und des Spannungsempfängers (1) jeweils von Trenchgräben (27) zur Spannungsisolation umgeben sind.

7. Schaltungsanordnung nach den Patentansprüchen 1 bis 6, **dadurch gekennzeichnet, dass** die Schaltungsanordnung zur Überbrückung hoher Spannungen mit einem Schaltsignal als mit Halbleiterprozessen für integrierte Hochvolt-Schaltungen mit beliebiger Isolation für den Spannungssender (2), die Hochvoltkapazitäten und den Spannungsempfänger (1) hergestellte integrierte Halbleiterschaltungen realisiert ist.

**Claims**

1. Circuit arrangement for bridging high voltages using a switching signal, wherein

   - a voltage transmitter (2) having first and second terminals (7/Vdd, 8/Vss) for a low voltage and a voltage receiver (1) having third and fourth terminals (11/Vddh1, 12/Vddh2) for a high voltage compared with the low voltage between the first and second terminals (7/Vdd, 8/Vss) each consists of a first inverter circuit and a second inverter circuit, wherein the inverter circuits of the voltage transmitter (2) are switched between the first and second terminals (7/Vdd, 8/Vss) and the inverter circuits of the voltage receiver (1) are connected between the third and fourth terminals (11/Vddh1, 12/Vddh2),
   - the output of the first inverter circuit (3) of the voltage transmitter (2) is interconnected over a first capacitor (C1) as high-voltage capacitance with the input of the second inverter circuit (6) of the voltage receiver (1) and the output of the first inverter circuit (5) of the voltage receiver (1) and
   - the output of the second inverter circuit (4) of the voltage transmitter (2) is interconnected over a second capacitor (C2) as high-voltage capacitance with the input of the first inverter circuit (5) of the voltage receiver (1) and the output of the second inverter circuit (6) of the voltage receiver (1),
   - the inputs of the first inverter circuit (3) and the second inverter circuit (4) each of the voltage transmitter (2) are a non-inverting and an inverting input and
   - the outputs of the first inverter circuit (5) and the second inverter circuit (6) each of the voltage receiver (1) are output nodes, **characterized by**
   - that a third inverter circuit (15) of the voltage transmitter (2) is switched between the first and second terminals (7/Vdd, 8/Vss),
   - that the output of the third inverter circuit (15) is interconnected with the input of the first inverter circuit (3) of the voltage transmitter (2),
   - that the input of the third inverter circuit (15) is interconnected with the input of the second inverter circuit (4) of the voltage transmitter (2),
   - that the input of the third inverter circuit (15) is interconnected with the terminal IN (16) as input of the circuit arrangement for bridging high voltages using a switching signal,
   - that a fourth inverter circuit (21) and a fifth inverter circuit (22) of the voltage transmitter (2) are switched between the first and second terminals (7/Vdd, 8/Vss),
   - that the input of the fifth inverter circuit (22) is interconnected with the input of the third inverter circuit (15) and with the terminal IN (16) as input of the circuit arrangement for bridging high voltages using a switching signal,
   - that the output of the fifth inverter circuit (22) is interconnected with the input of the fourth inverter circuit (21) and
   - that the output of the fourth inverter circuit (21) is interconnected with the input of the second inverter circuit (4) of the voltage transmitter (2).

2. Circuit arrangement to claim 1 **characterized by** that a third inverter circuit (17) and a fourth inverter circuit (18) of the voltage receiver (1) are switched between the third and fourth terminals (11/Vddh1, 12/Vddh2), that the input of the third inverter circuit (17) is interconnected with the input of the first inverter circuit (5) of the voltage receiver (1), that the input of the fourth inverter circuit (18) is interconnected with the input of the second inverter circuit (6) of the voltage receiver (1), that the output of the third inverter circuit (17) is interconnected with the terminal OUT1 (19) as the first output of the voltage receiver (1) and that the output of the fourth inverter circuit (18) is interconnected with the terminal OUT2 (20) as the second output of the voltage receiver (1).

3. Circuit arrangement to claims 1 and 2 **characterized by** that an inverter circuit consists of two complementary transistors switched in series.

4. Circuit arrangement to claim 1 **characterized by** that the first capacitor (C1) and the second capacitor (C2) are switched between the voltage transmitter (2) and the voltage receiver (1) in such manner that the first capacitor (C1) and the second capacitor (C2) each as high-voltage capacitors are charged to the voltage difference to be overcome between the voltage transmitter (2) and the voltage receiver (1) and then the charges of the first capacitor (C1) and second capacitor (C2) differ only by the value DQ = C x (Vdd - Vss) for signal transmission, whereby the power consumption of the circuit arrangement for bridging high voltages using a switching signal is independent of the voltage difference to be overcome between the voltage transmitter (2) and the voltage receiver (1) and at the same time the used differential principle (C1 is charged by DQ, C2 is decharged by DQ, and vice versa) guarantees a high signal-to-noise ratio against common-mode disturbance signals.

5. Circuit arrangement to claim 1 **characterized by** that the circuit arrangement for bridging high voltages using a switching signal as integrated semiconductor circuit manufactured using semiconductor processes is realised with CMOS circuits as inverter circuits as well as layer stacks with channel-stop implantation, field oxide, polysilicon, CVD-oxide, metal, CVD-oxide, metal, etc., wherein the layers are interconnected mutually, as first capacitor (C1) and as second capacitor (C2) each as high-voltage capacitor.

6. Circuit arrangement to claims 1 to 5 **characterized by** that the voltage transmitter (2) is a region or several regions (23a, 23b), that the first capacitor (C1) is a region (24) and the second capacitor (C2) is a region (25) and that the voltage receiver (1) is a region (26) of the semiconductor chip and that at least the regions of the voltage transmitter (2) or the 2 and the voltage receiver (1) each is surrounded by trenches (27) for voltage insulation.

7. Circuit arrangement to claims 1 to 6 **characterized by** that the circuit arrangement for bridging high voltages using a switching signal is realised as integrated semiconductor circuits manufactured using semiconductor processes for integrated high-voltage circuits with any insulation for the voltage transmitter (2), the high-voltage capacitors and the voltage receiver (1).

**Revendications**

1. Circuit pour court-circuiter des hautes tensions avec un signal de commutation, dans lequel un émetteur de tension (2) avec des première et deuxième connexions (7/Vdd, 8/Vss) pour une basse tension et un récepteur de tension (1) avec des troisième et quatrième connexions (11/Vddh1, 12/Vddh2) pour une tension élevée par rapport à la basse tension entre les première et deuxième connexions (7/Vdd, 8/Vss) sont composés chacun d'un premier circuit inverseur et d'un deuxième circuit inverseur, les circuits inverseurs de l'émetteur de tension (2) étant branchés entre les première et deuxième connexions (7/Vdd, 8/Vss) et les circuits inverseurs du récepteur de tension (1) entre les troisième et quatrième connexions (11/Vddh1, 12/Vddh2),

- la sortie du premier circuit inverseur (3) de l'émetteur de tension (2) étant reliée par une première capacité (C1) sous forme de capacité haute tension à l'entrée du deuxième circuit inverseur (6) du récepteur de tension (1) et à la sortie du premier circuit inverseur (5) du récepteur de tension (1) et
- la sortie du deuxième circuit inverseur (4) de l'émetteur de tension (2) étant reliée par une deuxième capacité (C2) sous forme de capacité haute tension à l'entrée du premier circuit inverseur (5) du récepteur de tension (1) et à la sortie du deuxième circuit inverseur (6) du récepteur de tension (1),
- les entrées du premier circuit inverseur (3) et du deuxième circuit inverseur (4) de l'émetteur de tension (2) étant respectivement une entrée non inverseuse et une entrée inverseuse et
- les sorties du premier circuit inverseur (5) et du deuxième circuit inverseur (6) du récepteur de tension (1) constituant chaque fois un noeud de sortie, **caractérisé en ce**
- **qu'**un troisième circuit inverseur (15) de l'émetteur de tension (2) est branché entre les première et deuxième connexions (7/Vdd, 8/Vss),
- **que** la sortie du troisième circuit inverseur (15) est reliée à l'entrée du premier circuit inverseur (3) de l'émetteur de tension (2),
- **que** l'entrée du troisième circuit inverseur (15) est reliée à l'entrée du deuxième circuit inverseur (4) de l'émetteur de tension (2),
- **que** l'entrée du troisième circuit inverseur (15) est reliée à la connexion IN (16) servant d'entrée du circuit pour court-circuiter des hautes tensions avec un signal de commutation,
- **qu'**un quatrième circuit inverseur (21) et un cinquième circuit inverseur (22) de l'émetteur de tension (2) sont branchés entre les première et deuxième connexions (7/Vdd, 8/Vss),
- **que** l'entrée du cinquième circuit inverseur (22) est reliée à l'entrée du troisième circuit inverseur (15) et à la connexion IN (16) servant d'entrée du circuit pour court-circuiter des hautes tensions avec un signal de commutation,

- **que** la sortie du cinquième circuit inverseur (22) est reliée à l'entrée du quatrième circuit inverseur (21) et

- **que** la sortie du quatrième circuit inverseur (21) est reliée à l'entrée du deuxième circuit inverseur (4) de l'émetteur de tension (2).

2. Circuit selon la revendication 1, **caractérisé en ce qu'**un troisième circuit inverseur (17) et un quatrième circuit inverseur (18) du récepteur de tension (1) sont branchés entre les troisième et quatrième connexions (11/Vddh1, 12/Vddh2), que l'entrée du troisième circuit inverseur (17) est reliée à l'entrée du premier circuit inverseur (5) du récepteur de tension (1), que l'entrée du quatrième circuit inverseur (18) est reliée à l'entrée du deuxième circuit inverseur (6) du récepteur de tension (1), que la sortie du troisième circuit inverseur (17) est reliée à la connexion OUT1 (19) servant de première sortie du récepteur de tension (1) et que la sortie du quatrième circuit inverseur (18) est reliée à la connexion OUT2 (20) servant de deuxième sortie du récepteur de tension (1).

3. Circuit selon les revendications 1 et 2, **caractérisé en ce qu'**un circuit inverseur est composé de deux transistors complémentaires branchés en série.

4. Circuit selon la revendication 1, **caractérisé en ce que** la première capacité (C1) et la deuxième capacité (C2) sont branchées entre l'émetteur de tension (2) et le récepteur de tension (1) de façon que la première capacité (C1) et la deuxième capacité (C2), chacune sous forme de capacité haute tension, soient chargées à la différence de tension à surmonter entre l'émetteur de tension (2) et le récepteur de tension (1) et que leur charge varie ensuite seulement de la valeur $DQ = C \times (Vdd-Vss)$ pour la transmission des signaux, la consommation de puissance du circuit pour court-circuiter des hautes tensions avec un signal de commutation étant indépendante de la différence de tension à surmonter entre l'émetteur de tension (2) et le récepteur de tension (1) et en même temps le principe différentiel utilisé (C1 est chargé de DQ, C2 est déchargé de CQ et vice-versa) garantissant en même temps un rapport signal/bruit élevé par rapport aux signaux de bruit en mode commun.

5. Circuit selon la revendication 1, **caractérisé en ce que** le circuit pour court-circuiter des hautes tensions avec un signal de commutation est réalisé sous la forme d'un circuit intégré à semi-conducteurs fabriqué avec des procédés de semi-conducteurs d'une part avec des circuits CMOS comme circuits inverseurs et d'autre part avec des piles de couches avec implantation de stoppeurs de canal, oxyde de champ, polysilicium, oxyde par CVD, métal, oxyde par CVD, métal, etc., les couches étant connectées électriquement en alternance, comme première capacité (C1) et comme deuxième capacité (C2), chacune sous forme de capacité haute tension.

6. Circuit selon les revendications 1 à 5, **caractérisé en ce que** l'émetteur de tension (2) est une région ou plusieurs régions (23a, 23b) de la puce à semi-conducteurs, que la première capacité (C1) est une région (24) et la deuxième capacité (C2) une région (25) de la puce à semi-conducteurs et que le récepteur de tension (1) est une région (26) de la puce à semi-conducteurs et qu'au moins les régions de l'émetteur de tension (2) ou de l'émetteur de tension (2) et du récepteur de tension (1) sont entourées chaque fois de tranchées (27) pour l'isolation de tension.

7. Circuit selon les revendications 1 à 6, **caractérisé en ce que** le circuit pour court-circuiter des hautes tensions avec un signal de commutation est réalisé sous la forme de circuits intégrés à semi-conducteurs fabriqués avec des procédés de semi-conducteurs pour circuits intégrés haute tension à isolation quelconque pour l'émetteur de tension (2), les capacités haute tension et le récepteur de tension (1).

Figur 1

Figur 2

Figur 3

Figur 4

EP 1 573 915 B1

Figur 5

15

EP 1 573 915 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19502116 C2
- WO 0070763 A
- JP 2001223575 A
- US 4723082 A

**In der Beschreibung aufgeführte Nicht-Patentliteratur**

- **DECLERCQ, M.** 5 V-to-75 V CMOS Output Interface Circuits. *1993 IEEE International Solid-State Circuits Conference,* 1993, 162-163
- **BALLAN, H.** High voltage devices and circuits in standard CMOS technology. Kluwer Academic Publishers, 1999, 182 ff